# EUROPÄISCHE PATENTSCHRIFT

(11) **EP 1 256 144 B1**
(45) Veröffentlichungstag und Bekanntmachung des Hinweises auf die Patenterteilung: **01.10.2003**
(21) Anmeldenummer: 01911408.1
(22) Anmeldetag: 31.01.2001
(51) Int. Cl.: H01R 12/04

(54) **VERFAHREN ZUR KONTAKTIERUNG EINER LEITERPLATTE MIT EINER AUF EINEM TRÄGER ANGEORDNETEN LEITERBAHN UND VORRICHTUNG**
METHOD FOR CONTACTING A PRINTED CIRCUIT BOARD TO A CONDUCTOR ARRANGED ON A SUPPORT, AND DEVICE
PROCEDE POUR L'ETABLISSEMENT D'UN CONTACT ENTRE UNE CARTE DE CIRCUITS IMPRIMES ET UN CIRCUIT IMPRIME DISPOSE SUR UN SUPPORT, ET DISPOSITIF

(30) Priorität: 01.02.2000 DE 10004162
(43) Veröffentlichungstag der Anmeldung: 13.11.2002
(73) Patentinhaber: ROBERT BOSCH GMBH, 70442 Stuttgart (DE)
(72) Erfinder: PREISSL, Reinhold, 70439 Stuttgart (DE)
(86) Internationale Anmeldenummer: DE0100383
(87) Internationale Veröffentlichungsnummer: WO01057960

(56) Entgegenhaltungen:
- WO-A-92/21167
- DE-A- 19 817 198
- DE-C- 19 811 610
- DE-U- 8 429 939
- US-A- 4 157 932
- US-A- 5 255 155
- US-A- 5 788 532

## Beschreibung

### Stand der Technik

Die Erfindung geht aus von einem Verfahren nach der Gattung des Hauptanspruchs. Aus der US 5,255,155 ist es bekannt, Leiterplatten in einem Kraftfahrzeug anzuordnen und mittels Folienleiterbahnen zu verbinden. Hierbei ist es jedoch erforderlich, die Leiterplatten schon vor einer Montage in dem Fahrzeug elektrisch leitend mit den Folien zu verbinden und dann die bereits verbundenen Leiterplatten mit den Folien in dem Kraftfahrzeug zu montieren. Insbesondere bei der Montage in einem Cockpitmodul, in dem z.B. eine Klimasteuerung, ein Radio und Anzeigeinstrumente angeordnet sind, müssen eine Vielzahl von Leiterplatten gleichzeitig montiert werden. Hierbei können die Folienleiterbahnen mechanisch belastet und zerstört werden. Ferner ist es bei Komponenten, die von verschiedenen Herstellern erzeugt werden, möglicherweise erforderlich, die Führung der Leiterbahnfolien an die Anschlüsse der einzelnen Leiterplatten anzupassen, wodurch bei dem Schnitt der Leiterbahnfolien ein hoher Verlust entstehen kann oder eine Vielzahl verschieden zugeschnittener Leiterbahnfolien erforderlich ist.

### Vorteile der Erfindung

Das erfindungsgemäße Verfahren mit den Merkmalen des Hauptanspruchs hat demgegenüber den Vorteil, daß es ohne einen hohen Montageaufwand möglich ist, mehrere Leiterplatten in einem Fahrzeug elektrisch leitend miteinander zu verbinden. Da zunächst in einem Metallisierungsprozeß alle notwendigen Leiterbahnen auf einem Träger aufgebracht werden, ist es anschließend auf einfache Weise möglich, eine Leiterplatte einzeln auf diesem Träger anzuordnen. Die Anordnung von Leiterplatten kann somit nacheinander erfolgen. Hierdurch ist es insbesondere möglich, nach jeder Anordnung zu prüfen, ob die einzelnen Leiterplatten jeweils auch vollständig elektrisch leitend kontaktiert wurden. Ein weiterer Vorteil ist, daß auf Verbindungsdrähte oder Folienleiterbahnen, die von der Leiterplatte wegführen, verzichtet werden kann, da alle Leiterbahnen, die zu der Leiterplatte führen, bereits in dem Träger vorhanden sind. Die an dem Träger angeordneten Leiterbahnen können vor einer Installation von Leiterplatten auf ihre Leitfähigkeit und/oder auf Kurzschlüsse geprüft werden.

Durch die in den Unteransprüchen aufgeführten Maßnahmen sind vorteilhafte Weiterbildungen und Verbesserungen des im Hauptanspruch angegebenen Verfahrens möglich. Besonders vorteilhaft ist es, wenn die Leiterplatte mit einem Leitkleber an einen bei der Metallisierung der Oberfläche des Trägers erzeugten, hervorstehenden Kontakt mit einem Leitkleber angeklebt wird. Hierdurch ist es möglich, den Fertigungsschritt der Anordnung der Leiterplatte auf das Auftragen eines Leitklebers und das Anordnen der Leiterplatte an den Kontakt zu reduzieren. Während der Oberflächenmetallisierung kann der entsprechende Kontakt an der Oberfläche des Trägers mit ausgeformt werden.

Weiterhin ist es vorteilhaft, die Leiterplatte mit einer dafür vorgesehenen Öffnung um einen an der Oberfläche des Trägers befindlichen Kontakt anzuordnen, um mit einem Prägestempel diesen Kontakt so zu verbreitern, daß er einerseits die Leiterplatte hält und sich andererseits ein elektrischer Kontakt zu einer dafür vorgesehenen Fläche auf der Leiterplatte ergibt. Somit kann in einem Fertigungsschritt sowohl ein tragender Kontakt als auch eine elektrische Verbindung zwischen der Leiterplatte und dem Träger erstellt werden.

Weiterhin ist es vorteilhaft, eine Vielzahl von Leiterplatten in einem Fahrzeug nach dem erfindungsgemäßen Verfahren zu verbinden, da auf einfache Weise eine elektrische Verbindung direkt über die Herstellung des Trägers realisiert werden kann.

Ferner ist es vorteilhaft, daß auf der Leiterplatte bereits elektrische Bauelemente angeordnet sind, so daß die Leiterplatte fertig montiert in das Fahrzeug eingebracht werden kann. Dabei ist es weiterhin vorteilhaft, daß der Träger ein Teil eines Gehäuses für die mindestens eine Leiterplatte ist, so daß der Träger nicht nur die Leiterplatte trägt, sondern auch einen mechanischen Schutz für die Leiterplatte darstellt. Ferner ist es vorteilhaft, den Träger teilweise aus metallisierbarem und teilweise aus metallabweisendem Polyamid zu fertigen, da so eine Herstellung des Trägers im Spritzgußverfahren auf einfache Weise möglich ist. Bei der Erstellung eines Cockpitmoduls kann hierdurch die äußere Form des Trägers an eine für die Form des Cockpitmoduls gewünschte Form angepaßt werden.

Ferner ist es vorteilhaft, daß die mindestens eine Leiterplatte eine flexible Folie ist, so daß sie sich auch an eine nicht plane Gestaltung des Trägers anpassen kann, wie es z.B. eine abgerundete Oberfläche eines Cockpitmoduls erfordert.

### Zeichnung

Ausführungsbeispiele der Erfindung sind in der Zeichnung dargestellt und in der nachfolgenden Beschreibung näher erläutert. Es zeigen die Figuren 1a, 1b und 1c ein erstes Ausführungsbeispiel für ein erfindungsgemäßes Verfahren zur Kontaktierung einer Leiterplatte mit einem Träger, die Figuren 2a, 2b und 2c ein zweites Ausführungsbeispiele für ein erfindungsgemäßes Verfahren zur Kontaktierung einer Leiterplatte mit einem Träger, die Figuren 3a bis 3e ein drittes Ausführungsbeispiel für ein erfindungsgemäßes Verfahren zur Kontaktierung einer Leiterplatte mit einem Träger. Die Figur 4 zeigt eine erfindungsgemäße Anordnung von mehreren Leiterplatten auf einem Träger, die Figur 5a zeigt eine erfindungsgemäße Anordnung mehrerer Leiterplatten in einem Cockpitmodul eines Kraftfahrzeugs, die Figur 5b zeigt ein erfindungsgemäßes Ausführungsbeispiel für eine Verschaltung mehrerer, an einem Kraftfahrzeug angeordneter Leiterplatten.

### Beschreibung des Ausführungsbeispiels

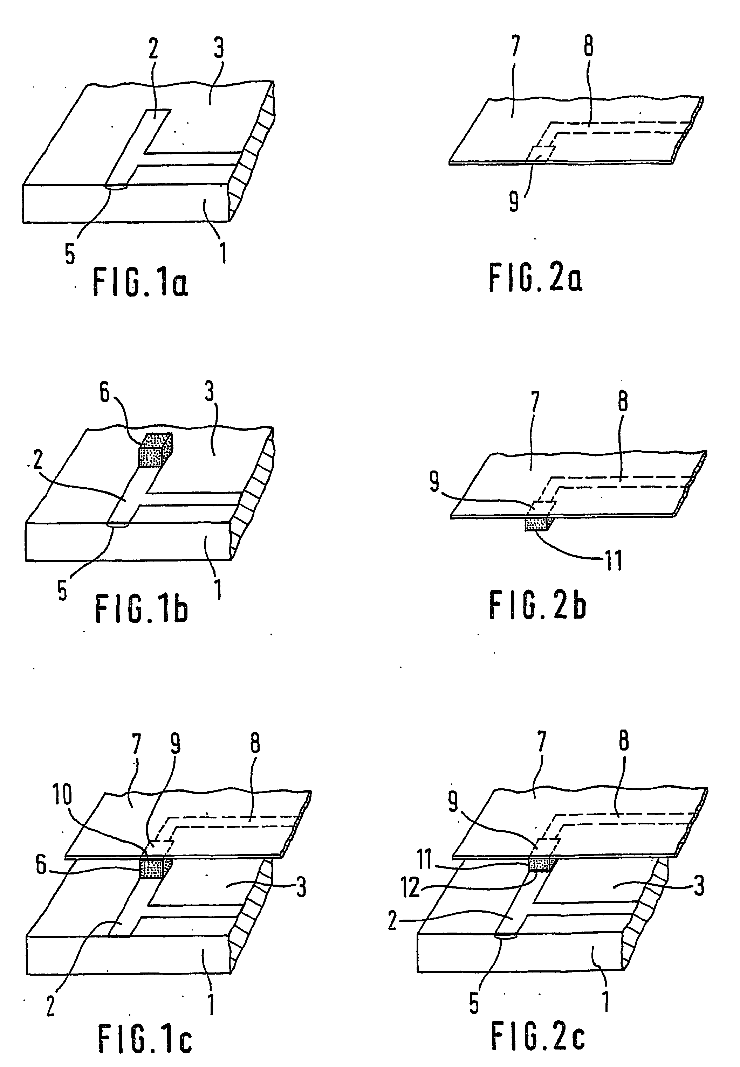

In der Figur 1a ist ein Träger 1 dargestellt, der eine Oberfläche 3 aufweist. Auf der Oberfläche 3 ist eine zweite Leiterbahn 2 aufgebracht. Von dem Träger 1 und der zweiten Leiterbahn 2 ist lediglich ein kleiner Ausschnitt dargestellt, an dem ein Kontakt zu einer Leiterplatte erstellt wird. Der Träger 1 ist vorzugsweise aus einem Kunststoffmaterial gefertigt, z. B. Polyamid. Bis auf einen, sich an der zweiten Leiterbahn 2 befindlichen Bereich 5 des Trägers 1 ist der Träger aus einem metallabweisenden Material gefertigt, an dem Metall z.B. in einem Lötbad oder bei einer Bedampfung nicht oder nur sehr schlecht haftet. Der Bereich 5, der an der Oberfläche 3 des Trägers liegt, ist jedoch so gefertigt, daß Metall bei einem Löttauchbad oder bei einer Bedampfung anhaftet. Die zweite Leiterbahn 2 führt z.B. zu einem in dem Träger befindlichen, elektrischen Steckanschluß oder zu einer weiteren Leiterplatte. Der Träger 1 ist vorzugsweise als ein Cockpitmodul in einem Kraftfahrzeug ausgeführt, wobei an dem Cockpitmodul Anzeigeinstrumente und Bedienelemente angeordnet sind, so z.B. die Geschwindigkeitsanzeige und das Radio, die in der Figur nicht dargestellt sind. Auf die zweite Leiterbahn 2 wird ein Kontakt 6 aufgebracht, wobei der Kontakt 6 vorzugsweise aus einem Metall besteht. Dies ist in der Figur 1b dargestellt. Hier und im folgenden entsprechen gleiche Bezugszeichen auch gleichen Elementen. Der Kontakt 6 wird z.B. während der Metallisierung der Oberfläche 3 mit aufgebracht. Ferner ist es auch möglich, den Kontakt z.B. in einem Lötbad an der Oberfläche 3 anzubringen. Anschließend werden eine Leiterplatte 7 mit einer ersten Leiterbahn 8 und einem Kontaktbereich 9 an dem Kontakt 6 angeordnet, wie es in der Figur 1c dargestellt ist. Die erste Leiterbahn 8 und der Kontaktbereich sind gestrichelt dargestellt. Sie befinden sich auf der dem Träger 1 zugewandten Seite der Leiterplatte 7. In einem in der Figur nicht dargestellten Ausführungsbeispiel ist die erste Leiterbahn 8 auch auf die dem Träger 1 abgewandte Seite der Leiterplatte 7 geführt. In der Figur 1c ist nur ein Ausschnitt aus der Leiterplatte 7 dargestellt, die Umgebung des Kontaktbereichs 9. Auf der Leiterplatte 7 angeordnete elektrische Bauelemente sind in der Figur nicht dargestellt. Indem vor einer Kontaktierung Leitkleber 10, also elektrisch leitfähiger Klebstoff, auf den Kontaktbereich 9 und/oder den Kontakt 6 aufgebracht wird, besteht nun ein leitfähiger Kontakt zwischen der ersten Leiterbahn 8 und der zweiten Leiterbahn 2. Das Verfahren ist nicht auf die Anordnung von Leiterplatten und Trägern mit jeweils einer Leiterbahn beschränkt, sondern es können auch mehrere Leiterbahnen auf einem Träger mit mehreren metallischen Kontakten in einem Fertigungsschritt mit einer Leiterplatte mit einer Vielzahl von Kontaktbereichen und Leiterbahnen kontaktiert werden.

Anhand der Figuren 2a-2c wird ein weiteres erfindungsgemäßes Verfahren zur Kontaktierung beschrieben. In der Figur 2a ist die Leiterplatte 7 mit der ersten Leiterbahn 8 in dem Kontaktbereich 9 dargestellt. Auf den Kontaktbereich 9 wird ein zweiter metallischer Kontakt 11 aufgebracht. Dies ist in der Figur 2b gezeigt. Das Aufbringen kann z.B. durch das Aufbringen von Lötzinn erfolgen. In der Figur 2c ist die Leiterplatte 7 dargestellt, die mittels Leitkleber 12 über den Kontaktbereich 9 mit der zweiten Leiterbahn 2 auf der Oberfläche 3 des Trägers 1 kontaktiert worden ist. Das zu den Figuren 2a bis 2c beschriebene Verfahren unterscheidet sich von dem zu den Figuren 1a bis 1c beschriebenen Verfahren dadurch, daß hier zunächst ein metallischer Kontakt auf der Leiterplatte 7 angeordnet wird, der erst anschließend mit der zweiten Leiterbahn 2 auf dem Träger 1 in Kontakt gebracht wird.

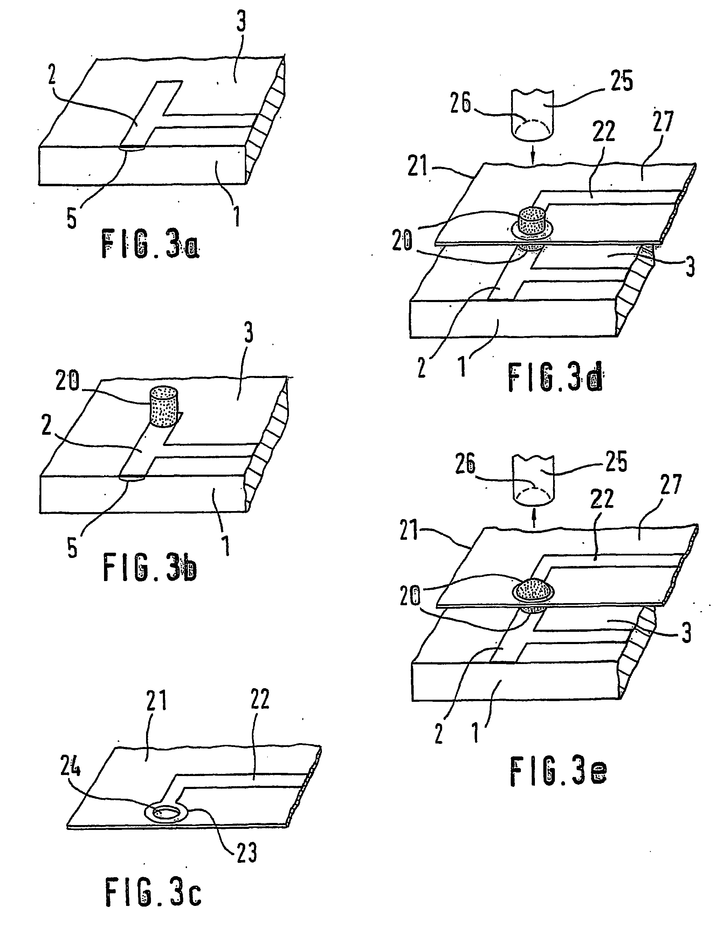

Anhand der Figuren 3a-3e ist ein weiteres erfindungsgemäßes Verfahren beschrieben. Ausgehend von dem Träger 1, wie er in der Figur 3a dargestellt ist und zu der Figur 1a beschrieben wurde, wird ein metallischer Kontakt 20 auf die zweite Leiterbahn 2 aufgebracht. Dies ist in der Figur 3b dargestellt. Der metallische Kontakt 20 ist vorzugsweise zylinderförmig ausgeführt. Der metallische Kontakt 20 kann entweder durch Leitkleber auf die zweite Leiterbahn 2 geklebt werden oder bei der Metallisierung der Oberfläche 3 ausgeformt werden. Auch ist die Anordnung eines metallischen Stiftes möglich, z.B. in einer Vertiefung des Trägers 1. In der Figur 3c ist eine zweite Leiterplatte 21 dargestellt.

Auf der zweiten Leiterplatte 21 ist auf einer dem Träger 1 abgewandten Oberfläche 27 eine erste Leiterbahn 22 angeordnet. Die erste Leiterbahn 22 und die zweite Leiterplatte 21 weisen eine Öffnung 24 auf, die von einem elektrisch mit der ersten Leiterbahn 22 verbundenen Kontaktbereich 23 umgeben ist. Die zweite Leiterplatte 21 wird über den metallischen Kontakt 20 mit der Öffnung 24 gestülpt. Ein Prägestempel 25 bewegt sich an der dem Träger abgewandten Seite der zweiten Leiterplatte 21 auf den metallischen Kontakt 20 zu. Dies ist in der Figur 3d dargestellt. Durch den Prägestempel 25 wird der dritte metallische Kontakt in die Breite gedrückt und über den Kontaktbereich 23 der zweiten Leiterplatte 21 erweitert. Der metallische Kontakt hält nun, wie in der Figur 3e dargestellt, die zweite Leiterplatte 21 auf oder knapp über der Oberfläche 3 des Trägers 1. Ferner steht die erste Leiterbahn 22 mit der zweiten Leiterbahn 2 über den metallischen Kontakt 20 und den Kontaktbereich 23 in einer elektrisch leitenden Verbindung. Der Prägestempel 25 ist vorzugsweise erhitzbar ausgeführt, so daß er während seiner Berührung des metallischen Kontaktes 20 den metallischen Kontakt 20 erwärmt und formt. Hierzu ist der Prägestempel 25 auf seiner dritten, dem metallischen Kontakt 20 zugewiesenen Seite vorzugsweise konkav ausgeführt. Dies ist in der Zeichnung durch eine gestrichelte Linie 26 dargestellt. Nach dem Prägen des metallischen Kontaktes 20 wird der Prägestempel 25 wieder von der zweiten Leiterplatte 21 entfernt. Die Bewegung des Prägestempels ist in den Figuren 3d und 3e durch Pfeile in Richtung des Trägers 1 und von dem Träger 1 weg weisend angedeutet. In der Figur 3e ist die fertig mit dem Träger 1 kontaktierte zweite Leiterplatte 21 dargestellt.

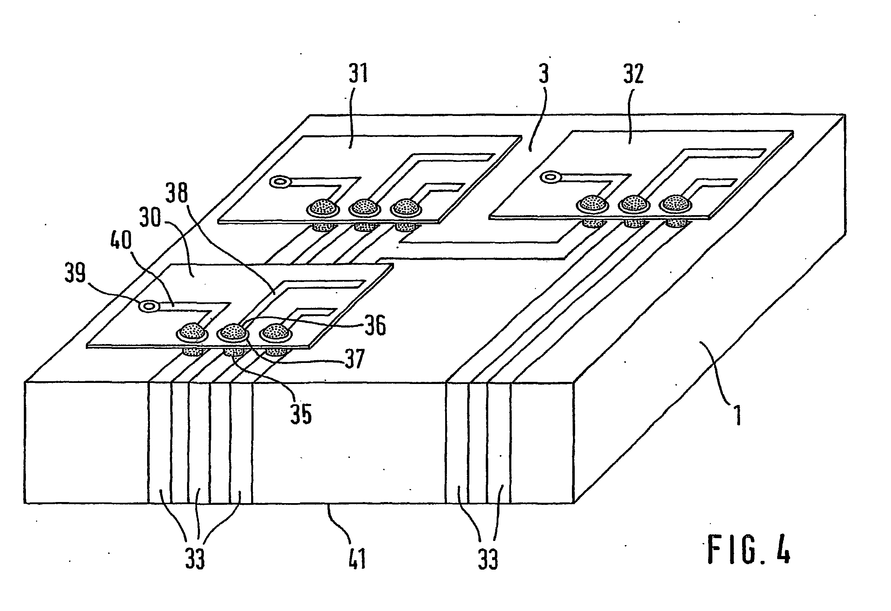

In der Figur 4 ist ein Träger 1 dargestellt, auf dessen Oberfläche 3 eine erste Leiterplatte 30, eine zweite Leiterplatte 31 und eine dritte Leiterplatte 32 angeordnet ist. Die Leiterplatten sind durch auf der Oberfläche 3 angeordnete Leiterbahnen 33 elektrisch leitend miteinander verbunden. Mit den Leiterbahnen 33 stehen die Leiterplatten 30, 31 und 32 über metallische Kontakte in Verbindung. Die metallischen Kontakte sind nach dem zu den Figuren 3a - 3e beschriebenen Verfahren erstellt. Für die nähere Beschreibung ist ein metallischer Kontakt 35 ausgewählt. Über einen oberen Bereich 36 steht der metallische Kontakt 35 in Verbindung zu einem Randbereich 37 einer Leiterbahn 38, die auf der ersten Leiterplatte 30 angeordnet ist. Eine weitere Leiterbahn 40 auf der ersten Leiterplatte 30 weist einen Steckkontakt 39 auf. Aus Gründen der Übersichtlichkeit sind auf den Leiterplatten angeordnete Bauelemente in der Figur 4 nicht eingezeichnet. Der Träger 1 weist eine Vorderseite 41 auf, die der Oberfläche 3 gegenüberliegt und auf die die Leiterbahnen von der Oberfläche 3 geführt werden. Sie verlaufen dann auf der Vorderseite 41 weiter. Dies ist in der Zeichnung nicht dargestellt.

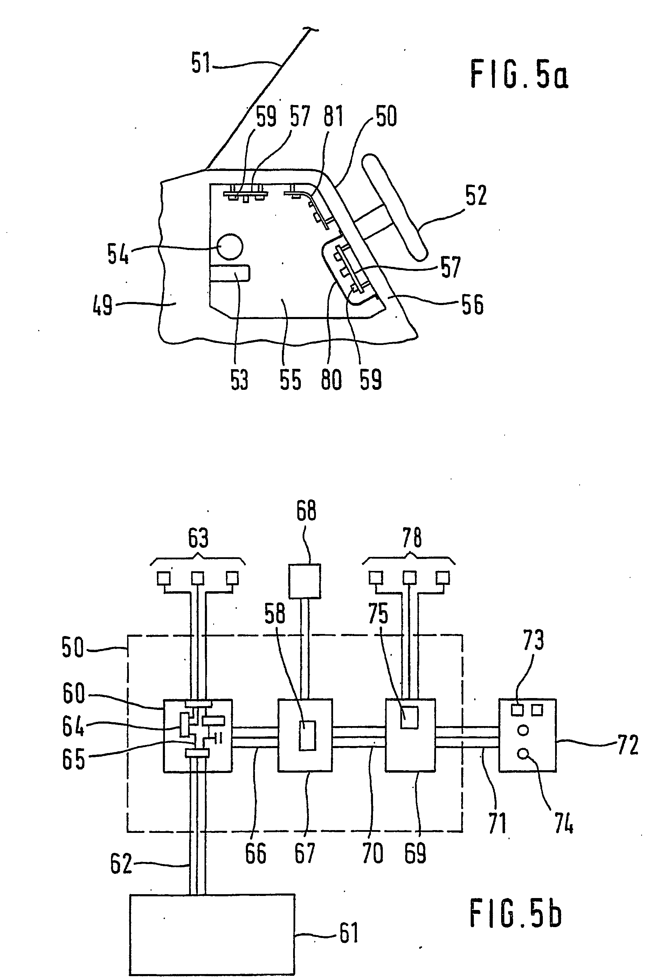

In der Figur 5a ist ein Querschnitt durch ein Cockpitmodul 50 in einem Kraftfahrzeug dargestellt. Das Cockpitmodul 50 befindet sich in einem vorderen Bereich des Fahrzeugs und schließt einerseits an einer Windschutzscheibe 51 und andererseits an einen Motorraum 49 des Fahrzeugs an. Vor dem Cockpitmodul 50 befindet sich ein Lenkrad 52. Im Cockpitmodul befinden sich Trageelemente 53, sowie Versorgungsleitungen 54, wie z. B. Leitungen für die Luftzufuhr. Das Cockpitmodul weist einen Hohlraum 55 auf, in dem neben den genannten Trageelementen 53 und Versorgungsleitungen 54 weitere Elemente angeordnet sind, z.B. elektrische Versorgungsleitungen, die aus Gründen der Übersichtlichkeit der Zeichnung in der Figur nicht eingezeichnet sind. Die Wände 56 des Cockpitmoduls 50 sind als Träger für Leiterplatten 57 ausgeführt. Dabei bilden die Wände 56 außerdem einen Sicht- und Berührschutz gegenüber einem sich vor dem Lenkrad 52 befindenden Benutzer des Fahrzeugs. Die Leiterplatten 57 sind in der zu den Figuren 1a bis 1c, 2a bis 2c, bzw. 3a bis 3e beschriebenen Verfahren auf die als Träger fungierenden Wände 56 des Cockpitmoduls 50 angeordnet. Die Leiterplatten dienen z. B. der Ansteuerung von Anzeigeinstrumenten, dem Radio, der Klimasteuerung und/oder einer Navigationsvorrichtung in dem Fahrzeug. Auf den Leiterplatten sind elektrische Bauelemente 59 angeordnet, vorzugsweise durch einen Lötprozeß, insbesondere in SMD-Technik. Eine flexible Leiterplatte 81, die aus einer flexiblen Folie gefertigt ist, ist in einer Ecke des Cockpitmoduls 50 angeordnet und paßt sich an die Form des Cockpitmoduls 50 an. Eine Abdeckung 80 umgibt eine der Leiterplatten 57. Die Abdeckung 80 dient der elektromagnetischen Abschirmung und ist z.B. aus einem leitfähigen Kunststoff ausgeführt. Die Abstrahlung elektromagnetischer Strahlen, mit denen z.B. Schaltungen auf den übrigen Leiterplatten beeinflußt werden könnten, wird zumindest vermindert.

In der Figur 5b ist eine Schaltung zwischen einzelnen Funktionsgruppen und den Leiterplatten schematisch dargestellt. Das Cockpitmodul 50 ist durch eine gestrichelte Umrandung dargestellt. Eine erste Leiterplatte 60 dient der Ansteuerung einer Anzeigevorrichtung 61, zu der mehrere Leiterbahnen 62 führen. Bei den einzelnen Verbindungen von Leiterbahnen zu anderen Elementen in der Figur 5b stehen die eingezeichneten Leiterbahnen symbolisch für eine Vielzahl von Leiterbahnen. Die Anzahl der Leiterbahnen richtet sich nach der z.B. für eine Spannungsversorgung und eine Datenübertragung erforderliche Anzahl von Leiterbahnen. In der Anzeigevorrichtung 61 werden z.B. Geschwindigkeit und Drehzahl des Fahrzeugs angezeigt. Diese werden von Sensoren 63, die außerhalb des Cockpitmoduls 50 im Fahrzeug angeordnet sind, erfaßt und an eine Auswerteelektronik, die auf der ersten Leiterplatte 60 angeordnet ist, weitergeleitet. Elektrische Bauelemente 64 sind auf der ersten Leiterplatte 60 angedeutet. Ebenso sind Leiterbahnen 65 auf der ersten Leiterplatte 60 angeordnet. Die erste Leiterplatte 60 ist über Leiterbahnen 66, die auf der Oberfläche des Cockpitmoduls angeordnet sind, mit einer zweiten Leiterplatte 67 verbunden. Die zweite Leiterplatte 67 ist mit einem GPS-Empfänger 68 verbunden. Das GPS-Signal wird von einer auf der zweiten Leiterplatte 67 angeordneten Recheneinheit 58 ausgewertet und für eine Ortung einer Fahrzeugposition verwendet. Die von der Recheneinheit 58 ermittelten Daten werden an eine auf der ersten Leiterplatte 60 angeordnete Ansteuerungselektronik der Anzeigevorrichtung 61 weitergeleitet und gelangen in der Anzeigevorrichtung 61 zur Anzeige. Die zweite Leiterplatte 67 ist mit einer dritten Leiterplatte 69 über Leiterbahnen 70 verbunden, und die dritte Leiterplatte 69 ist wiederum über Leiterbahnen 71 mit einem Bedienelement 72 verbunden, das über Druckknöpfe 73 und/oder Drehknöpfe 74 verfügt. Mit dem Bedienelement 72 ist es möglich, die Anzeigevorrichtung 61, die zumindest zur Ortung verwendete Recheneinheit 58 und eine auf der dritten Leiterplatte 69 angeordnete Klimasteuervorrichtung 75 zu beeinflussen. Die Klimasteuervorrichtung 75 verfügt über nicht näher erläuterte Aktoren und Sensoren 78, über die Lüftungsklappen gesteuert werden und Temperaturen im Innenraum und Außenraum gemessen werden. Aus Gründen der Übersichtlichkeit der Zeichnung sind die Leiterbahnen auf der zweiten Leiterplatte 67 und der dritten Leiterplatte 69 nicht dargestellt.

## Patentansprüche

1. Verfahren zur elektrischen Kontaktierung einer Leiterplatte (7,21,30,57,60,81) und einem Träger (1,50) in einem Kraftfahrzeug, vorzugsweise in einem Cockpitmodul, mit einer auf der Leiterplatte angeordneten ersten Leiterbahn (8, 22, 65) und mit einer auf einem Träger angeordneten zweiten Leiterbahn, (2, 62, 66, 70) wobei der Träger vorzugsweise in einem Spritzgußverfahren teilweise aus einem metallisierbaren und teilweise aus einem metallabweisenden Werkstoff geformt wird, wobei die Oberfläche (3) des Trägers (1,50) mit metallabweisenden und mit metallisierbaren (5) Bereichen ausgeführt wird, wobei die zweite Leiterbahn durch eine Metallisierung des metallisierbaren Teils der Oberfläche des Trägers erstellt wird, wobei die erste Leiterbahn auf der Leiterplatte mit der zweiten Leiterbahn auf dem Träger elektrisch leitend verbunden wird und wobei die Leiterplatte von dem Träger getragen wird.

2. Verfahren nach Anspruch 1, **dadurch gekennzeichnet, daß** auf der zweiten Leiterbahn (2,62,66,70) bei der Metallisierung aus der Oberfläche (3) des Trägers (1,50) ein hervorstehender Kontakt (6,20,11,35) ausgeformt wird.

3. Verfahren nach Anspruch 2, **dadurch gekennzeichnet, daß** eine mit der ersten Leiterbahn verbundene Kontaktfläche (9) der Leiterplatte mit einem Leitkleber (10) an den Kontakt (6) angeklebt wird.

4. Verfahren nach einem der Ansprüche 2,3, **dadurch gekennzeichnet, daß** der Kontakt (20) in eine Öffnung (24) der Leiterplatte eingeführt wird, daß von einer von der der Oberfläche (3) des Trägers (1,50) abgewandten Seite der Leiterplatte ein Prägestempel (25) auf den Kontakt gedrückt wird, daß der Kontakt (20) durch die über den Prägestempel übertragene Kraft zumindest auf der der Oberfläche des Trägers abgewandten Seite der Leiterplatte verbreitert wird und daß der verbreiterte Kontakt auf eine an der Leiterplatte angeordnete, mit der ersten Leiterbahn (22) elektrisch leitend verbundene Fläche (25) gedrückt wird.

5. Verfahren nach Anspruch 4, **dadurch gekennzeichnet, daß** der Kontakt (20) während oder vor einer Berührung durch den Prägestempel (25) erhitzt wird.

6. Verfahren nach Anspruch 1, **dadurch gekennzeichnet, daß** auf der Leiterplatte ein mit der zweiten Leiterbahn (2) elektrisch leitend verbundener und über die Oberfläche (3) der Leiterplatte herausragender Kontakt (6) angeordnet wird und daß der Kontakt auf eine Kontaktfläche der ersten Leiterbahn geklebt wird.

7. Verfahren zum Verbinden von Leiterplatten in einem Kraftfahrzeug, wobei die Leiterplatten (57) nach einem Verfahren nach einem der vorherigen Ansprüche (1-6) mit einem Träger kontaktiert werden, **dadurch gekennzeichnet, daß** die Leiterplatten mit elektrischen Bauelementen bestückt werden, daß die Leiterplatten in einem Cockpitmodul (50) angeordnet werden und daß die Leiterplatten jeweils miteinander über auf dem Träger angeordnete zweiten Leiterbahnen elektrisch leitend verbunden werden.

8. Vorrichtung mit einem Träger (1, 50) und mit mindestens einer Leiterplatte (7, 21, 30, 57, 60, 81) in einem Kraftfahrzeug, wobei auf der Leiterplatte (7, 21, 30, 57, 60, 81) erste Leiterbahnen (8, 22, 65) und elektrische Bauelemente (59, 64) angeordnet sind, wobei auf dem Träger (1, 50) zweite Leiterbahnen (2, 62, 66, 70)angeordnet sind, und wobei die ersten und die zweiten Leiterbahnen nach einem Verfahren nach den Ansprüchen 1 bis 6 elektrisch leitend verbunden sind.

9. Vorrichtung nach Anspruch 8, **dadurch gekennzeichnet, daß** der Träger (1, 50) ein Teil eines Gehäuses für die mindestens eine Leiterplatte (7, 21, 30, 57, 60, 81) ist.

10. Vorrichtung nach einem der Ansprüche 8-9, **dadurch gekennzeichnet, daß** der Träger (1, 50) zumindest teilweise aus metallisierbarem Polyamid und zumindest teilweise aus metallabweisendem Polyamid gefertigt ist.

11. Vorrichtung nach einem der Ansprüche 8-10, **dadurch gekennzeichnet, daß** die mindestens eine Leiterplatte eine flexible Folie (81) ist.

12. Vorrichtung nach einem der Ansprüche 8-11, daß eine Vielzahl von Leiterplatten (30, 31, 32, 60, 67, 69) in dem Kraftfahrzeug angeordnet sind, daß auf den Leiterplatten (30, 31, 32, 60, 67, 69) die Ansteuerelektronik für eine Anzeigevorrichtung (61) , für eine Klimasteuerungsvorrichtung (75) , für eine Radiovorrichtung und/oder für eine Navigationsvorrichtung (58) angeordnet ist.

13. Vorrichtung nach Anspruch 12, **dadurch gekennzeichnet, daß** die Leiterplatten (30, 31, 32, 60, 67, 69) zumindest teilweise von einer elektromagnetischen Abschirmabdeckung (80) umgeben sind.

## Claims

1. Method for making electrical contact with a printed circuit board (7, 21, 30, 57, 60, 81) and a carrier (1, 50) in a motor vehicle, preferably in a cockpit module, having a first conductor track (8, 22, 65) which is arranged on the printed circuit board and having a second conductor track (2, 62, 66, 70) which is arranged on a carrier, the carrier being preferably moulded using an injection moulding method, partially from a metallizable and partially from a metal-repellent material, the surface (3) of the carrier (1, 50) being formed with metal-repellent and metallizable (5) regions, the second conductor track being created by metallizing the metallizable part of the surface of the carrier, the first conductor track on the printed circuit board being electrically conductively connected to the second conductor track on the carrier, and the printed circuit board being supported by the carrier.

2. Method according to Claim 1, **characterized in that**, during the metallization, a contact (6, 20, 11, 35) which protrudes from the surface (3) of the carrier (1, 50) is formed on the second conductor track (2, 62, 66, 70).

3. Method according to Claim 2, **characterized in that** a contact face (9), connected to the first conductor track, of the printed circuit board is bonded to the contact (6) using a conductive bonding agent (10).

4. Method according to either of Claims 2 and 3, **characterized in that** the contact (20) is introduced into an opening (24) in the printed circuit board, **in that** a die (25) is pressed onto the contact from one side of the printed circuit board facing away from the surface (3) of the carrier (1, 50), **in that** the contact (20) is widened by the force transmitted via the die, at least on the side of the printed circuit board facing away from the surface of the carrier, and that the widened contact is pressed on to a surface (25) which is arranged on the printed circuit board and is electrically conductively connected to the first conductor track (22).

5. Method according to Claim 4, **characterized in that** the contact (20) is heated during or before it is touched by the die (25).

6. Method according to Claim 1, **characterized in that** a contact (6) which is electrically conductively connected to the second conductor track (2) and protrudes above the surface (3) of the printed circuit board is arranged on the printed circuit board, and **in that** the contact is bonded to a contact face of the first conductor track.

7. Method for connecting printed circuit boards in a motor vehicle, the printed circuit boards (57) being placed in contact, according to a method according to one of the preceding claims (1-6), with a carrier, **characterized in that** the printed circuit boards are equipped with electrical components in such a way that the printed circuit boards are arranged in a cockpit module (50), and **in that** the printed circuit boards are each electrically conductively connected to one another via second conductor tracks which are arranged on the carrier.

8. Device having a carrier (1, 50) and having at least one printed circuit board (7, 21, 30, 57, 60, 81) in a motor vehicle, first conductor tracks (8, 22, 65) and electrical components (59, 64) being arranged on the printed circuit board (7, 21, 30, 57, 60, 81), second conductor tracks (2, 62, 66, 70) being arranged on the carrier (1, 50) and the first and second conductor tracks being electrically conductively connected according to a method according to Claims 1 to 6.

9. Device according to Claim 8, **characterized in that** the carrier (1, 50) is part of a housing for the at least one printed circuit board (7, 21, 30, 57, 60, 81).

10. Device according to either of Claims 8 and 9, **characterized in that** the carrier (1, 50) is fabricated at least partially from metallizable polyamide and at least partially from metal-repellent polyamide.

11. Device according to one of Claims 8-10, **characterized in that** the at least one printed circuit board is a flexible film (81).

12. Device according to one of Claims 8-11, **characterized in that** a multiplicity of printed circuit boards (30, 31, 32, 60, 67, 69) are arranged in the motor vehicle, **in that** the drive electronics for a display device (61), for an air-conditioning control device (75), for a radio device and/or for a navigation device (58) are arranged on the printed circuit boards (30, 31, 32, 60, 67, 69).

13. Device according to Claim 12, **characterized in that** the printed circuit boards (30, 31, 32, 60, 67, 69) are at least partially surrounded by an electromagnetic screening cover (80).

## Revendications

1. Procédé pour l'établissement d'un contact électrique entre une carte de circuits imprimés (7, 21, 30, 57, 60, 81) et un support (1, 50) dans un véhicule automobile, de préférence dans un module de poste de pilote, avec un premier circuit imprimé (8, 22, 65) disposé sur la carte de circuits imprimés et avec un deuxième circuit imprimé (2, 62, 66, 70) disposé sur le support, le support étant de préférence fabriqué lors d'un procédé de moulage par injection partiellement à partir de matières premières pouvant être métallisées et partiellement à partir de matières premières repoussant le métal, la surface (3) du support (1, 50) étant composée de zones repoussant le métal et de zones pouvant être métallisées (5), le deuxième circuit imprimé étant fabriqué en métallisant la pièce métallisable de la surface du support, le premier circuit imprimé disposé sur la carte de circuits imprimés étant relié de manière à laisser passer l'électricité dans le deuxième circuit imprimé disposé sur le support et la carte de circuits imprimés étant placée sur le support.

2. Procédé selon la revendication 1,
**caractérisé en ce que**
lors de la métallisation à partir de la surface (3) du support (1, 50), un contact en saillie (6, 20, 11, 35) est déformé sur le deuxième circuit imprimé (2, 62, 66, 70).

3. Procédé selon la revendication 2,
**caractérisé en ce qu'**
une surface de contact (9) reliée au premier circuit intégré de la carte de circuits imprimés est collée au contact (6) à l'aide d'une colle conductrice (10).

4. Procédé selon l'une des revendications 2 ou 3,
**caractérisé en ce que**
le contact (20) est inséré dans une ouverture (24) de la carte de circuits imprimés, à partir d'un côté opposé à la surface (3) du support (1, 50) de la carte de circuits imprimés, un poinçon (25) est appliqué sur le contact, le contact (20) se propage au moins sur le côté opposé à la surface du support de la carte de circuits imprimés, grâce à la force transmise via le poinçon, et le contact propagé s'appuie sur une surface située sur la carte de circuits imprimés et reliée au premier circuit électrique (22) de manière à laisser passer l'électricité.

5. Procédé selon la revendication 4,
**caractérisé en ce que**
le contact (20) s'échauffe au cours d'un contact via le poinçon (25) ou avant celui-ci.

6. Procédé selon la revendication 1,
**caractérisé en ce qu'**
un contact (6) en saillie relié au deuxième circuit électrique (2) de manière à laisser passer l'électricité et situé sur la surface (3) de la carte de circuits imprimés est placé sur la carte de circuits imprimés, et le contact est collé à une surface de contact du premier circuit imprimé.

7. Procédé permettant de relier les cartes de circuits imprimés d'un véhicule automobile, au cours duquel les cartes de circuits imprimés (57) sont mises en contact avec un support, selon un procédé conforme à l'une des revendications 1 à 6 précédentes,
**caractérisé en ce que**
les cartes de circuits imprimés sont constituées de composants électriques, les cartes de circuits imprimés sont placées dans un module du poste de pilotage (50), et les cartes de circuits imprimés sont respectivement reliées les unes aux autres de manière à laisser passer l'électricité via les deuxièmes circuits imprimés disposés sur le support.

8. Dispositif comprenant un support (1, 50) et au moins une carte de circuits imprimés (7, 21, 30, 57, 60, 81) dans un véhicule automobile, dans lequel les premiers circuits imprimés (8, 22, 65) et les composants électriques (59, 64) sont placés sur la carte de circuits imprimés (7, 21, 30, 57, 60, 81), les deuxièmes circuits imprimés (2, 62, 66, 70) sont placés sur le support (1, 50) et les premiers et les deuxièmes circuits imprimés sont reliés les uns aux autres de manière à laisser passer l'électricité, selon un procédé conforme aux revendications 1 à 6.

9. Dispositif selon la revendication 8,
**caractérisé en ce que**
le support (1, 50) est une pièce d'un boîtier pour au moins une carte de circuits imprimés (7, 21, 30, 57, 60, 81).

10. Dispositif selon l'une des revendications 8-9,
**caractérisé en ce que**
le support (1, 50) est composé au moins partiellement de polyamide pouvant être métallisé et au moins partiellement de polyamide repoussant le métal.

11. Dispositif selon l'une des revendications 8-10,
**caractérisé en ce qu'**
au moins une carte de circuits imprimés est une feuille flexible (81).

12. Dispositif selon l'une des revendications 8-11,
**caractérisé en ce qu'**
un grand nombre de cartes de circuits imprimés (30, 31, 32, 60, 67, 69) est placé dans le véhicule automobile, et l'électronique de commande est placée sur les cartes de circuits imprimés (30, 31, 32, 60, 67, 69) pour un dispositif d'affichage (61), pour un dispositif de contrôle de climatisation (75), pour un dispositif radio et/ou pour un dispositif de navigation (58).

13. Dispositif selon la revendication 12,
**caractérisé en ce que**
les cartes de circuits imprimés (30, 31, 32, 60, 67, 69) sont au moins partiellement entourées d'une couverture de blindage électromagnétique (80).
